Europäisches Patentamt

European Patent Office

Office européen des brevets

(19)

(11) Numéro de publication: **0 012 092**

**B1**

(12) **FASCICULE DE BREVET EUROPEEN**

(45) Date de publication du fascicule du brevet: **31.08.83**

(21) Numéro de dépôt: **79400958.9**

(22) Date de dépôt: **04.12.79**

(51) Int. Cl.³: **G 08 B 13/26,**
G 08 B 29/00, G 01 R 17/06

(54) **Système de sécurité.**

(30) Priorité: **05.12.78 FR 7834188**

(43) Date de publication de la demande:
**11.06.80 Bulletin 80/12**

(45) Mention de la délivrance du brevet:
**31.08.83 Bulletin 83/35**

(84) Etats contractants désignés:
**AT BE CH DE GB IT LU NL SE**

(56) Documents cités:
**US - A - 2 031 951**
**US - A - 3 423 748**
**US - A - 4 063 447**

(73) Titulaire: **METAFIX Société anonyme:**
**Avenue Eugène Gazeau Zace**
**F-60300 Senlis (FR)**

(73) Titulaire: **TREFILUNION Société anonyme**
**B.P. 55**
**F-52102 Saint-Dizier (FR)**

(72) Inventeur: **Dray, Jacques**
**11 rue du Vieux Chemin de Meaux**
**F-60300 Senlis (FR)**
Inventeur: **Canobbio, Paul**
**9 chemin de la Bigüe**
**F-60300 Senlis (FR)**

(74) Mandataire: **Laget, Jean-Loup et al,**
**Cabinet Pierre Loyer 18, Rue de Mogador**
**F-75009 Paris (FR)**

Courier Press, Leamington Spa, England.

Système de sécurité

La présente invention concerne les systèmes de sécurité du type utilisable chaque fois qu'il est nécessaire de pouvoir détecter, en vue de déclencher une alarme, une indication visuelle et (ou) audible ou une manoeuvre ou intervention correctrice manuelle ou automatique, la variation ou modification d'une condition d'un ensemble, d'un appareil ou d'un dispositif comprenant au moins un élément conducteur normalement présent ou incorporé intentionnellement à cet ensemble, appareil ou dispositif.

Elle concerne plus particulièrement les systèmes de sécurité du type comprenant un circuit en pont dont l'une au moins des branches renferme un élément conducteur tel qu'un fil conducteur ou un ensemble de fils conducteurs dont on veut contrôler l'impédance, tandis que les autres branches renferment des éléments étalons et (ou) compensateurs, ce pont étant normalement équilibré, de sorte qu'une variation d'une caractéristique électrique de l'élément conducteur, comme sa résistance ou son impédance, provoque un déséquilibre du pont qui est détecté pour déclencher l'alarme ou l'intervention. Un tel système de sécurité est utilisable notamment dans le cas d'une clôture de sécurité ou d'un système analogue composé de fils conducteurs et entourant, en vue de sa protection, un site ou ensemble de sites tel que des habitations, pylônes, usines, centrales, sites militaires ou civils, etc.... lorsqu'on désire détecter toute tentative d'effraction ou toute intervention non autorisée sur cette clôture ou ce système analogue.

On a déjà proposé, dans la demande de brevet français n° 78—00017 publiée par le document FR—A—2 413 729, le 27.7.1979 après la date de priorité de la présente demande, dans un système du type considéré comportant un circuit en pont, de prévoir, dans une autre branche du pont, un élément compensateur tel qu'un autre fil conducteur soumis aux mêmes conditions climatiques que l'élément conducteur dont on contrôle la caractéristique électrique, afin d'éviter le déclenchement de fausses alarmes par suite d'une variation des conditions climatiques telles que les conditions de températures auxquelles l'élément conducteur considéré est soumis. Du fait que l'élément conducteur dont on contrôle la caractéristique et l'élément compensateur se trouvent chacun dans une branche du pont, si ces éléments sont composés de matériaux identiques, une compensation naturelle de température s'établit.

Cependant, cette compensation n'est pas parfaite car chacun des éléments peut se trouver à une température légèrement différente, due par exemple, notamment dans le cas de l'incorporation du système à une clôture, à une ombre projetée sur une partie d'un élément ou à toute autre raison, telle qu'un courant d'air, etc..., de sorte qu'il en résulte une dérive de la caractéristique contrôlée de cet élément par rapport à l'autre et que la compensation désirée n'est pas absolue.

Un but de l'invention est de réaliser une compensation de la dérive due soit à une variation de température entre l'élément à contrôler et l'élément compensateur, soit à tout autre facteur.

On a également déjà proposé, dans le brevet des Etats Unis d'Amérique n° 4 063 447, de réaliser un circuit assurant la compensation de la dérive d'un circuit en pont. Mais il s'agit dans ce cas d'une application très particulière dans laquelle le circuit en pont comprend des sources de courant de référence et de mesure dont les caractéristiques sont modifiées, pour la compensation de la dérive, par détection d'un signal à la signal à la sortie du pont à un moment auquel un tel signal ne devrait pas apparaître, c'est-à-dire dans la condition de repos du pont. Or un tel agencement n'est pas utilisable dans un système de sécurité, étant donné que le circuit doit être maintenu en état de veille, ce qui exclut les périodes de repos en vue d'un contrôle de l'équilibre du pont et de la correction de la dérive.

Un autre but de l'invention est de réaliser une compensation de la dérive alors que le circuit est en état de veille, et même simultanément à une détection d'alarme, l'agencement étant tel qu'aucune compensation n'intervienne en cas de déséquilibre provoqué par exemple par une tentative d'intrusion et déclenchant une alarme, tandis qu'au contraire une alarme n'est pas déclenchée lors de la détection d'une dérive.

Il est connu depuis longtemps, comme décrit par exemple dans le brevet des Etats Unis d'Amérique n° 2 031 951, d'utiliser dans un circuit en pont incorporé à un système de sécurité une détection de variation d'impédance pour déclencher une alarme. Toutefois, un tel système connu ne comporte aucune compensation de dérive et ne résout pas en conséquence le problème posé, indiqué précédemment.

L'invention part donc d'un système de sécurité du type comprenant: un circuit en pont comportant, dans l'une de ses branches, un élément conducteur dont on veut contrôler l'impédance et dans ses autres branches des éléments étalons et (ou) compensateurs; des moyens pour l'alimentation de ce pont en courant alternatif; des moyens pour détecter un déséquilibre du pont résultant d'un changement brusque d'impédance de cet élément conducteur dû à une tentative d'intrusion, pour déclencher une alarme ou une intervention; et des moyens pour compenser la dérive de ce circuit en pont due à l'élément à contrôler et résoud le problème précité en étant, caractérisée en ce que l'un au moins des éléments étalons est un élément d'impédance variable; en ce que des moyens sont prévus pour détecter le décalage de phase du signal obtenu à la sortie du pont, dû à une faible variation d'impédance par dérive, par rapport au courant alternatif d'alimentation; et en ce que d'autres moyens sont prévus pour provoquer, à partir de la détection de ce décalage de phase, une modification de l'impédance de cet élément ou de ces éléments étalons pour compenser la dérive du pont due à l'élément conducteur a contrôler.

Les signaux pouvant résulter d'une dérive et apparaissant à la sortie du pont peuvent correspondre à quatre possibilités, à savoir:

— une diminution de la résistance R de l'élément à contrôler,

— une augmentation de la résistance R de cet élément à contrôler,

— une diminution du coefficient d'impédance pure Z de l'élément à contrôler,

— une augmentation du coefficient d'impédance pure Z de cet élément à contrôler.

Dans un tel cas, il est prévu des moyens pour détecter la dérive résultant d'une diminution ou augmentation de la résistance ou d'une diminution ou augmentation du coefficient d'impédance pure de l'élément à contrôler et pour identifier le type de dérive, et des moyens pour faire varier la condition de l'élément ou des éléments étalons variables dans un sens compensant ou annulant le signal de dérive correspondant.

Suivant une autre particularité de l'invention, les moyens prévus à la sortie du pont et détectant la dérive sont reliés à des circuits à retard ou à tout autre moyen localisant le signal de dérive dans le temps, agissant pour appliquer au signal de dérive des retards différents correspondant aux quatre possibilités précitées, et il est prévu un générateur de fréquence de synchronisation dérivée de la fréquence d'alimentation du pont, des circuits détecteurs de coïncidence pour détecter la coïncidence entre cette fréquence de synchronisation et l'un des degrés de retard fournis par les circuits à retard, des relais excités à partir de ces circuits à coïncidence quand une coïncidence est détectée, et des moyens agissant sélectivement dans le sens requis sur les éléments étalons pour faire varier leur caractéristique et rétablir l'équilibre du pont.

Suivant une particularité encore, des moyens sont prévus pour assurer la sélection des signaux apparaissant à la sortie du pont en cas de dérive, pour les séparer de la fréquence d'alimentation du pont.

Suivant une variante, la sortie du générateur de fréquence de synchronisation dérivée de la fréquence d'alimentation du pont est appliquée aux circuits à retard, qui appliquent à cette fréquence des retards étagés, et les signaux de dérive obtenus à la sortie du pont sont, après mise en forme, appliqués aux circuits de coïncidence, reliés eux-mêmes aux circuits à retard, afin de détecter ainsi la coïncidence entre le signal de dérive mis en forme obtenu à partir du circuit en pont et l'un des temps de retard de la fréquence de synchronisation, le signal de coïncidence alors obtenu étant appliqué à un relais ou analogue pour actionner les moyens agissant sélectivement dans le sens requis sur les éléments étalons pour faire varier leur caractéristique et rétablir l'équilibre du pont.

Suivant une autre particularité, il est prévu dans le circuit commandant ou réglant les éléments étalons un dispositif de temporisation qui retarde au degré désiré la correction de la dérive. Ainsi, étant donné qu'en cas d'intrusion ou analogue, la réponse du pont sous forme d'un signal d'alarme est immédiate, ce signal peut déclencher l'alarme du fait même du temps de réponse du système d'asservissement des éléments étalons.

Lors de la coupure du circuit d'alarme pour interrompre celle-ci, le signal détecté à la sortie du pont est alors transmis au système d'asservissement, ce qui établit automatiquement l'équilibre du pont.

Dans le cas d'un agencement du type faisant l'objet de l'invention, on peut prévoir dans deux branches du pont des masses métalliques, ainsi que des moyens pour détecter le déséquilibre du pont alimenté en courant alternatif résultant de la variation de couplage inductif due au rapprochement ou à l'écartement de ces masses métalliques. Ces masses peuvent être elles-mêmes composées par exemple de fils, grillages, tôles, plaques ou analogues, en tout matériau métallique. Elles peuvent être séparées par tout moyen désiré, notamment par de l'eau, un liquide, une mousse plastique, un ressort ou autre.

Cet agencement permet de réaliser le système de sécurité, notamment sous forme d'un tapis de détection qui peut être posé sur le sol ou enterré, en étant caché à la vue de toute manière désirée, ou qui peut être placé sur un mur, un plafond, dans un local ou hors de celui-ci, ou bien dans ou sur n'importe quel terrain.

Avec cet agencement, il est possible également de détecter toute variation du couplage entre les deux masses métalliques résultant de la présence d'un corps métallique à proximité de l'une des plaques ou entre celles-ci.

La description qui va suivre, faite en regard des dessins annexés, donnés à titre non limitatif, permettra de mieux comprendre l'invention.

La Fig. 1 est une représentation schématique d'un système de sécurité avec asservissement pour la compensation de la dérive.

La Fig. 2 est un schéma explicatif.

La Fig. 3 montre une variante de réalisation.

La Fig. 4 est une représentation schématique d'un système comportant des masses métalliques dont la variation d'écartement est détectée.

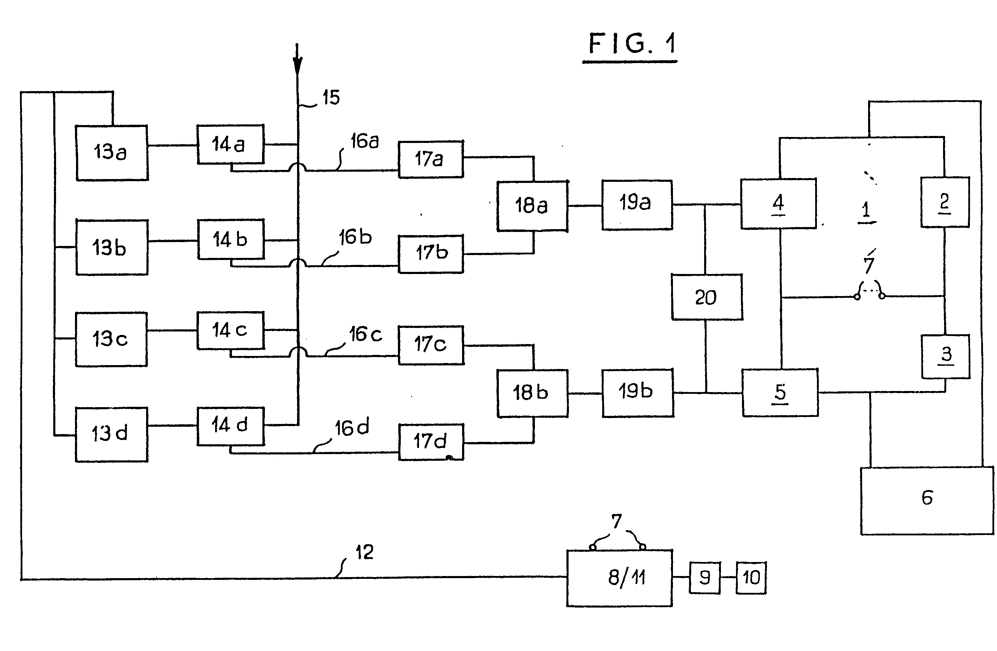

Sur la Fig. 1, on a désigné d'une façon générale par la référence 1 un pont de type général connu, comprenant un élément 2 tel qu'un fil conducteur dont la variation de caractéristique, par exemple d'impédance, doit être contrôlée, et un autre élément 3 analogue au précédent et placé dans les mêmes conditions climatiques. Les autres branches du pont renferment deux éléments étalons 4, 5 qui, dans le cas présent, sont réglables par variation de leur résistance et de leur impédance pure. Ce pont est alimenté à partir d'une source de tension alternative 6 et, en cas de déséquilibre, un signal apparaît sur ses bornes 7.

Pour faciliter la représentation, on a montré de façon séparée sur la Fig. 1 les bornes 7, qui sont reliées à un circuit 8 connecté à un circuit d'auto-maintien 9 et à un circuit d'alarme 10 de la façon déjà connue, de façon à déclencher une alarme ou à provoquer une intervention en cas de déséquilibre du pont, par exemple lors d'une intrusion.

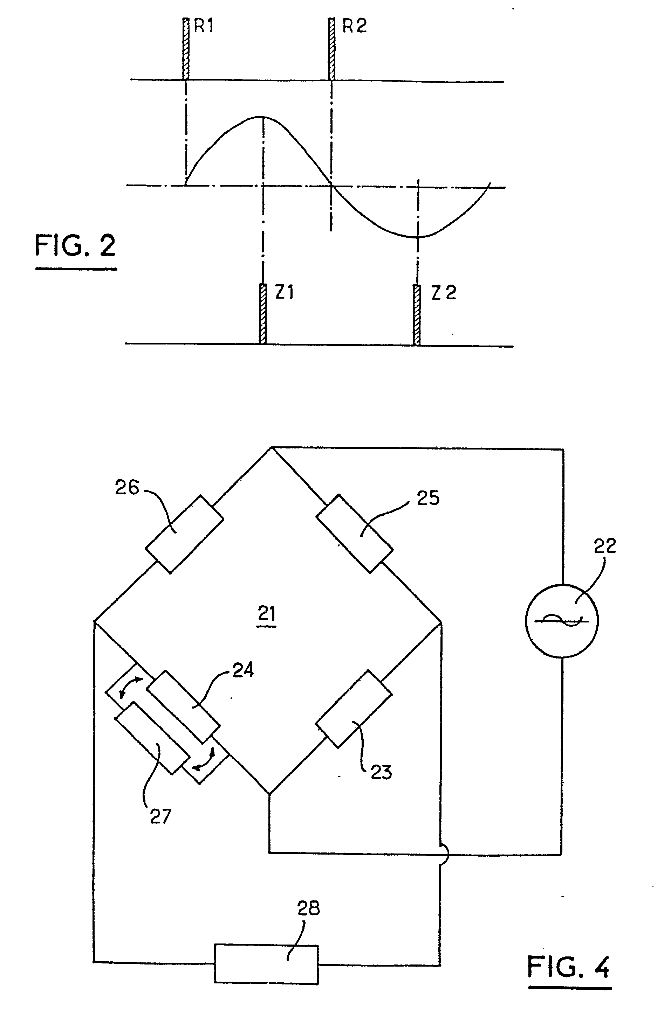

Le signal qui apparaît sur les bornes 7 lors d'une dérive est une forme d'onde qui met en évidence le décalage de phase fourni par la résistance R et le coefficient d'impédance pure Z. Ce décalage apparaît par rapport à la sinusoïde qui représente le signal d'alimentation du pont, fourni à partir de la source 6. Le décalage est détecté dans le circuit il à la sortie de l'ensemble amplification/traitement, avant le réglage du seuil de déclenchement de l'alarme, ce qui fournit ainsi par sélection des signaux dérive mis en forme. Ces signaux de dérive diffèrent au point de vue décalage de phase selon la nature de la dérive, comme indiqué précédemment. Ce décalage est bien visible sur le schéma qui forme la Fig. 2, sur laquelle R1 et R2 correspondent à des signaux de dérive résultant d'une variation de résistance et Z1 et Z2 à des signaux de dérive résultant d'une variation d'impédance pure ou d'inductance. La sinusoïde représente l'alimentation du pont à partir de la source 6. Du fait de cette diversité de nature de la dérive, il est alors nécessaire de séparer et d'identifier les signaux de dérive pour la correction ou l'asservissement.

Suivant le mode de réalisation décrit, le train de signaux de dérive sélecté par le circuit 11 est appliqué par un conducteur 12 à quatre circuits à retard 13a, 13b, 13c et 13d. Ces circuits à retard peuvent être constitués par des lignes à retard de type classique ou par d'autres systèmes équivalents, Ils sont réglés pour fournir des retards différents, variant d'un quart de période de la fréquence d'alimentation, en fonction des quatre possibilités précitées, à savoir la diminution ou l'augmentation de la résistance et la diminution ou l'augmentation du coefficient d'impédance pure. La sortie des circuits à retard est appliquée (sous forme de créneaux pour pouvoir travailler en circuits logiques) à des circuits à coïncidence 14a—14d, qui reçoivent par ailleurs par un conducteur 15 la fréquence de synchronisation dérivée de la fréquence d'alimentation du pont, après mise en créneau.

Lorsqu'une coïncidence est détectée entre la fréquence de synchronisation et un signal provenant d'un circuit à retard 13a—13d, un signal d'asservissement est transmis par l'un des conducteurs 16a—16d à l'un des quatre relais 17a—17d.

Ces relais sont reliés par paires chaque fois à un inverseur de marche 18a—18b. Ainsi, les relais 17a, 17d, sont reliés à l'inverseur 18a et les relais 17c, 17d sont reliés à l'inverseur 18b. Chaque inverseur de marche est relié lui-même à un moteur 19a, 19b, ces moteurs étant reliés par ailleurs respectivement aux éléments étalons variables ou réglables 4, 5.

On comprend que, pour chaque paire de relais 17a, 17b, d'une part, et 17c, 17d, d'autre part, le moteur 19a, 19b va tourner dans un sens ou dans l'autre selon le circuit à coïncidence 14a—14d transmettant un signal, de manière à compenser la dérive détectée sur les bornes 7 du pont 1.

Une minuterie de temporisation avec réglage de seuil 20 est montée entre les deux voies de correction de dérive, afin de déclencher l'asservissement à la hauteur, avec le retard et pendant un temps désirés, et pour que le circuit réagisse de la manière requise à des déséquilibres provenant par exemple d'une intrusion, c'est-à-dire à des déséquilibres devant donner lieu à une alarme.

Dans un tel cas, lors de la coupure du circuit d'alarme et du rétablissement de la condition normale de l'élément ou des éléments conducteurs, dont la condition a été modifiée par l'intrusion ou analogue, le système d'asservissement intervient pour rétablir l'équilibre du pont par une correction assurée sur l'élément ou les éléments étalons requis. Ainsi, aucun nouveau réglage manuel n'est nécessaire et la condition de veille du système est rétablie.

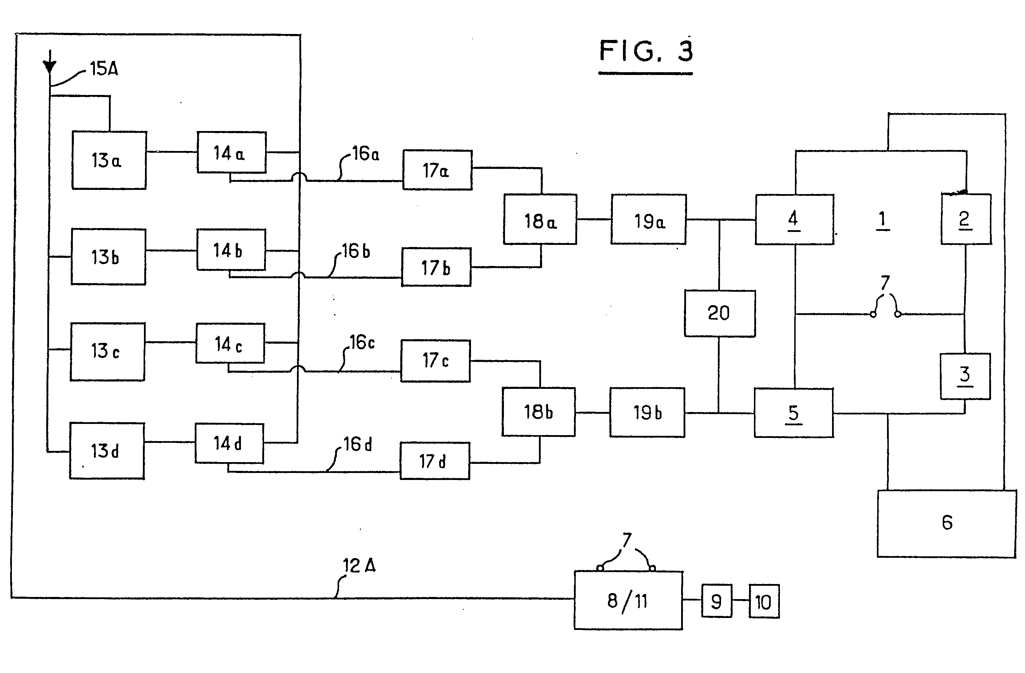

La variante de réalisation que montre la Fig. 3 diffère de l'agencement faisant l'objet de la Fig. 1 par le fait que les circuits à retard agissent sur la fréquence de synchronisation dérivée de la fréquence d'alimentation du pont fournie par la source 6, cette fréquence de synchronisation étant appliquée aux circuits à retard 13a à 13d par le conducteur 15A. Par ailleurs, les signaux de dérive mis en forme sont appliqués directement aux circuits de coïncidence 14a à 14d par le conducteur 12A comme montré.

La fréquence de synchronisation subit, dans les circuits à retard, des retards étagés d'un quart de période, et selon la nature de la dérive, qui peut avoir son origine comme indiqué précédemment dans quatre variations de caractéristique différentes, une coïncidence s'établit et est détectée dans l'un des circuits de coïncidence 14a à 14d. Cette détection de coïncidence fournit ici encore un signal de sortie qui agit comme précédemment pour compenser la dérive et pour rétablir l'équilibre du pont.

Si l'on se reporte à la Fig. 4, on voit qu'on a représenté un circuit en pont désigné d'une façon générale par la référence 21 et alimenté à partir d'une source de courant alternatif 22. Une première masse métallique 23 est montée dans une branche du pont, tandis qu'une seconde masse métallique 24 est montée dans une seconde branche, les deux autres branches comportant des éléments étalons 25, 26.

Dans le cas du mode de réalisation considéré, une autre masse métallique encore, indiquée en 27, est montée en parallèle avec la ·masse 24 dans le branche considérée du pont. On a indiqué schématiquement en 28 le système de traitement et d'alarme qui est relié à la sortie du pont. On comprend aisément, à l'examen de la Fig. 4, que lors d'une modification de la distance entre les masses métalliques 24 et 27, il se produit une variation du couplage inductif entre les deux masses métalliques, de laquelle résulte un déséquilibre du pont qui est détecté à la sortie de celui-ci, afin de fournir une alarme ou de déclencher une intervention.

Comme indiqué précédemment, ces masses métalliques peuvent être composées de fils, grillage, tôles, plaques ou analogues, qui peuvent être placés dans tout milieu désiré et notamment enfouis dans le sol. Une application possible correspond par exemple à la réalisation d'un tapis de sol comprenant les deux masses métalliques, dont le rapprochement sous l'effet d'une charge exercée sur le tapis va provoquer la variation de couplage inductif créant un déséquilibre du pont et par conséquent une alarme ou intervention.

On comprend toutefois que la seconde masse métallique, indiquée en 27 sur la Fig. 4, pourrait ne pas être matérialisée par une masse conjuguée de façon permanente à la masse métallique 24 et qu'il pourrait s'agir d'un volume métallique extérieur constitué par exemple par un véhicule, un engin, une personne portant des objets métalliques, etc. Il résulterait alors de la proximité de ce volume métallique avec la masse 24 une variation de couplage inductif provoquant le déséquilibre du pont et fournissant ainsi à la sortie de celui-ci un signal déclenchant une alarme ou une intervention.

Des modifications peuvent être apportées aux modes de réalisation décrits, dans le domaine des équivalences techniques, sans s'écarter de l'invention.

## Revendications

1. Système de sécurité du type comprenant: un circuit en pont (1) comportant, dans l'une de ses branches, un élément conducteur (2) dont on veut contrôler l'impédance et dans ses autres branches des éléments étalons et (ou) compensateurs (4, 5) des moyens (6) pour l'alimentation de ce pont en courant alternatif, des moyens (8/11) pour détecter un déséquilibre du pont (1) résultant d'un changement brusque d'impédance de cet élément conducteur (2) dû à une tentative d'intrusion, pour déclencher une alarme ou une intervention et des moyens pour compenser la dérive de ce circuit en pont (1) due à l'élément à contrôler, caractérisé en ce que l'un au moins des éléments étalons (4, 5) est un élément d'impédance variable en ce que des moyens (11, 13, 14) sont prévus pour détecter le décalage de phase du signal obtenu à la sortie du pont (1), dû à une faible variation d'impédance par dérive, par rapport au courant alternatif d'alimentation et en ce que d'autres moyens (17—20) sont prévus pour provoquer, à partir de la détection de ce décalage de phase, une modification de l'impédance de cet élément ou de ces éléments étalons (4, 5) pour compenser la dérive du pont (1) due à l'élément conducteur (2) à contrôler.

2. Système de sécurité suivant la revendication 1, dans lequel la dérive de l'élément à contrôler (2) peut résulter d'une ·variation dans un sens ou dans l'autre de la résistance ou du coefficient d'impédance pure de l'élément à contrôler, caractérisé en ce que les moyens (11, 13, 14) prévus pour détecter le décalage de phase entre le signal obtenu à la sortie du pont (1) et la fréquence d'alimentation déterminent, à partir de la valeur de ce décalage, la nature de la dérive par augmentation ou diminution de la résistance ou par augmentation ou diminution du coefficient d'impédance pure, en ce que des moyens (17) sont prévus pour produire, à partir de cette détermination, un signal d'asservissement, et en ce que les moyens (17—20) servant à compenser la dérive de l'élément à contrôler (2) sont agencés de manière à faire varier la condition de l'élément ou des éléments étalons (4, 5) dans un sens annulant ce signal d'asservissement.

3. Système de sécurité suivant la revendication 1 ou 2, caractérisé en ce que les moyens (8/11) prévus à la sortie du pont (1) et détectant la dérive sont reliés à des circuits à retard (13) agissant pour appliquer au signal de dérive des retards différents correspondant à la diminution ou à l'augmentation de la résistance ou bien à la diminution ou à l'augmentation du coefficient d'impédance pure de l'élément à contrôler, et en ce qu'il est prévu un générateur de fréquence de synchronisation, des circuits détecteurs de coïncidence (14) pour détecter la coïncidence entre cette fréquence de synchronisation et l'un des degrés de retard fournis par les circuits à retard (13), des relais (17) excités à partir de ces circuits à coïncidence quand une coïncidence est détectée, et des moyens (18—20) agissant sélectivement dans le sens requis sur les éléments étalons (4, 5) pour faire varier leur caractéristique et rétablir l'équilibre du pont.

4. Système de sécurité suivant la revendication 3, caractérisé en ce que la fréquence de synchronisation est dérivée de la fréquence d'alimentation du pont.

5. Système de sécurité suivant la revendication 1 ou 2, caractérisé en ce que des moyens sont prévus pour appliquer une fréquence de synchronisation dérivée de la fréquence d'alimentation du pont à des circuits à retard (13) agissant pour appliquer à cette fréquence de synchronisation des retards étagés d'un quart de période, les sorties des circuits à retard étant appliquées à des circuits détecteurs de coïncidence (14), et en ce que des moyens (8/11) prévus à la sortie du pont (1) et détectant la dérive sont reliés à ces circuits de coïncidence (14) de telle sorte qu'une coïncidence soit détectée dans l'un de ces circuits entre le signal de dérive et l'un des signaux correspondant à l'un des temps de retard de la fréquence de synchronisation, des relais (17) étant excités à partir de ces circuits à coïncidence (14) quand une coïncidence est détectée, des moyens (18—20) alimentés par ces relais agissant sélectivement dans le sens requis sur les éléments étalons pour faire varier leur caractéristique et rétablir l'équilibre du pont.

6. Système de sécurité suivant l'une quelconque des revendications précédentes, caractérisé en ce que des moyens (8/11) sont prévus pour assurer la sélection des signaux apparaissant à la sortie du pont en cas de dérive, pour les séparer de la fréquence d'alimentation du pont.

7. Système de sécurité suivant l'une quelconque des revendications précédentes, caractérisé en ce qu'il est prévu, dans le circuit commandant ou réglant les éléments étalons, un dispositif de temporisation (20) qui retarde la correction de la dérive.

8. Système de sécurité suivant l'une quelconque des revendications précédentes, caractérisé en ce qu'il comprend un circuit en pont (21) comportant, dans deux de ses branches, des masses métalliques (23, 24) et dans les autres branches des éléments étalons (25, 26), le pont (21) étant normalement équilibré, et en ce que des moyens (28) sont prévus pour détecter le déséquilibre du pont (1) résultant de la variation de couplage inductif due au rapprochement ou à l'écartement de ces masses métalliques (23, 24).

9. Système de sécurité suivant l'une quelconque des revendications 1 à 7, caractérisé en ce qu'il comprend un circuit en pont comportant, dans deux de ses branches, des masses métalliques (23, 24) et dans les autres branches des éléments étalons (25, 26), ainsi qu'une masse métallique additionnelle montée en parallèle avec l'une de ces masses métalliques, le pont (1) étant normalement équilibré, et en ce que des moyens sont prévus pour détecter le déséquilibre du pont résultant de la variation de couplage inductif due au rapprochement ou à l'écartement de cette masse métallique additionnelle par rapport à la masse métallique à laquelle elle est associée.

10. Système de sécurité suivant l'une quelconque des revendications 1 à 7, caractérisé en ce qu'il comprend un circuit en pont (1) comportant, dans deux de ses branches, des masses métalliques (23, 24), et dans les autres branches des éléments étalons (25, 26), le pont (1) étant normalement équilibré, et en ce que des moyens (28) sont prévus pour détecter le déséquilibre du pont (1) résultant de la variation de couplage inductif due à la proximité, par rapport à l'une de ces masses métalliques, d'un volume métallique extérieur.

## Claims

1. Security system of the type comprising: a bridge circuit (1) including, in one of its branches, a conductive element (2) the impedance of which it is desired to monitor and, in its other branches, calibrating and (or) compensating elements (4,5), means (6) for supplying the said bridge with alternating current, means (8/11) for detecting an imbalance of the bridge (1) resulting from a sudden change in the impedance of the said conductive element (2) due to an attempted intrusion, so as to set off an alarm or initiate an intervention, and means for compensating the drift of the said bridge circuit (1) due to the element to be monitored, characterised in that at least one of the calibrating elements (4, 5) is a variable impedance element, in that means (11, 13, 14) are provided for detecting the phase shift of the signal obtained at the output of the bridge (1) due to a slight variation of impedance by drift, with respect to the alternating supply current, in that other means (17—20) are provided in order to bring about, from the detection of this phase shift, an alteration of the impedance of the said calibrating element or elements (4, 5) so as to compensate the drift of the bridge (1) due to the conductive element to be monitored.

2. Security system according to claim 1, in which the drift of the element (2) to be monitored can result in a variation in one sense or the other of the resistance or of the coefficient of real impedance of the element to be monitored, characterised in that the means (11, 13, 14) provided for detecting the phase shift between the signal obtained at the output of the bridge (1) and the supply frequency determine, from the value of the said phase shift, the nature of the drift by increasing or reducing the resistance or by increasing or reducing the coefficient of real impedance, in that means (17) are provided for producing from this determination a control signal, and in that the means (17—20) which serve for compensating the drift in the element to be monitored (2) are arranged in such a manner as to cause the condition of the calibrating element or elements (4, 5) to be varied in a sense that will cancel the said control signal.

3. Security system according to claim 1 or 2, characterised in that the means (8/11) which are provided at the output of the bridge (1) and detect the drift are connected to delay circuits (13) arranged to apply to the drift signal different delays corresponding to the reduction of or increase in the resistance or else the reduction of or increase in the coefficient of real impedance of the element to be monitored and in that there are provided a synchronisation frequency generator, coincidence detecting circuits (14) for detecting coincidence between the said synchronisation frequency and the one of the degrees of delay provided by the delay circuits (13), relays (17) excited by the said coincidence circuits when a coincidence is detected and means (18—20) arranged selectively in the required sense on the calibrating elements (4, 5) so as to cause their characteristic to vary and to re-establish the balance of the bridge.

4. Security system according to claim 3, characterised in that the synchronisation frequency is derived from the supply frequency of the bridge.

5. Security system according to claim 1 or 2, characterised in that means are provided for applying a synchronisation frequency derived from the supply frequency of the bridge to delay circuits (13) arranged to apply to the said synchronisation frequency stepped delays of a quarter of a period, the outputs of the delay circuits being applied to coincidence detecting circuits (14), and in that the means (8/11) which are provided at the output of the bridge (1) and detect the drift are connected to the said coincidence circuits (14) in such a manner that a coincidence will be detected in one of the said circuits between the drift signal and one of the said signals corresponding to one of the delay periods of the synchronisation frequency, relays (17) being excited by the said coincidence circuits (14) when a coincidence is detected, means (18—20) supplied by the said relays being arranged selectively in the required sense on the calibrating elements so as to cause their characteristic to vary and to re-establish the balance of the bridge.

6. Security system according to any one of the preceding claims, characterised in that means (8/11) are provided for effecting the selection of the signals that appear at the output of the bridge in the case of drift, in order to separate them from the supply frequency of the bridge.

7. Security system according to any one of the preceding claims, characterised in that there is provided, in the circuit which controls or regulates the calibrating elements, a time-delay device (20) which delays the correction of the drift.

8. Security system according to any one of the preceding claims, characterised in that it comprises a bridge circuit (21) including metallic masses (23, 24) in two of its branches and calibrating elements (25, 26) in the other branches, the bridge (21) being normally balanced, and in that means (28) are provided for detecting the imbalance of the bridge (1) resulting from the variation of the inductive coupling due to the bringing together or separation of the said metallic masses (23, 24).

9. Security system according to any one of claims 1 to 7, characterised in that it comprises a bridge circuit including metallic masses (23, 24) in two of its branches and calibrating elements (25, 26) in the other branches, as well as an additional metallic mass connected in parallel with one of the said metallic masses, the bridge (1) being normally in balance, and in that means are provided for detecting the imbalance of the bridge resulting from the variation of the inductive coupling due to the bringing together or separation of the said additional metallic mass with respect to the metallic mass with which it is associated.

10. Security system according to any one of claims 1 to 7, characterised in that it comprises a bridge circuit (1) including metallic masses (23, 24) in two of its branches and calibrating elements (25, 26) in the other branches, the bridge (1) being normally in balance, and that means (28) are provided for detecting the imbalance of the bridge (1) resulting from the variation of the inductive coupling due to the proximity of an external metallic mass to one of the said metallic masses.

**Patentansprüche**

1. Sicherheitssystem des Typs, der aufweist: eine Brückenschaltung (1), mit einem Leiterelement (2), dessen Impedanz kontrolliert werden soll, in einem in einem ihrer Zweige und Normal- und/oder Kompensations-Elementen (4, 5) in ihren anderen Zweigen; Mittel (6) zur Versorgung dieser Brücke mit Wechselstrom; Mittel (8, 11) zur Feststellung eines Ungleichgewichts der Brücke (1) aufgrund einer plötzlichen Impedanzänderung des Leitelementes (2) infolge eines Einbruchversuchs sowie zur Auslösung eines Alarms oder anderen Eingriffs; und Mittel zum Ausgleich der durch das zu prüfende Element verursachten Verstimmung der Brückenschaltung (1), dadurch gekennzeichnet, daß mindestens eines der Normal-Elemente (4, 5) ein Element mit variabler Impedanz ist; daß Mittel (11, 13, 14) zur Feststellung einer Verschiebung der Phase des am Brückenausgang abgreifbaren Signals gegenüber der des Versorgungswechselstroms infolge einer geringen Impedanzänderung wegen der Verstimmung vorgesehen sind; und weitere Mittel (17—20) zur Einleitung einer Änderung der Impedanz des oder der Normal-Elemente, (4, 5) bei einer festgestellten Phasenverschiebung, um hierdurch die von dem zu prüfenden Leiterelement (2) verursachte Verstimmung der Brücke (1) auszugleichen.

2. Sicherheitssystem nach Anspruch 1, bei welchem die Verstimmung des zu prüfenden Elements (2) aus einer Änderung in der einen oder anderen Richtung des Widerstandes oder des reinen Impedanzkoeffizienten des zu prüfenden Elementes resultieren kann, dadurch gekennzeichnet, daß die zur Feststellung der Phasenverschiebung zwischen dem am Ausgang der Brücke (1) auftretenden Signal und der Versorgungsfrequenz vorgesehenen Mittel (11, 13, 14) aufgrund des Wertes dieser Verschiebung die Art der Verstimmung durch Erhöhung oder Verminderung des Widerstandes bzw. durch Erhöhung oder Verminderung des reinen Impedanzkoeffizienten bestimmen; daß Mittel (17) zu einer von dieser Bestimmung ausgehenden Erzeugung eines Steuersignals vorgesehen sind; und daß die zum Ausgleich der Verstimmung des zu prüfenden Elements (2) vorgesehenen Mittel (17—20) derart aufgebaut sind, daß sie den Zustand des oder der Normal-Elemente (4, 5) in einer das Steuersignal annulierenden Richtung verändern.

3. Sicherheitssystem nach Anspruch 1 oder 2, dadurch gekennzeichnet, daß die zur Feststellung der Verstimmung am Ausgang der Brücke (1) vorgesehenen Mittel (8/11) mit Verzögerungsschaltungen (13) verbunden sind, die das Abweichungs-Signal unterschiedlichen Verzögerungen, welche der Verminderung oder Erhöhung des Widerstandes bzw. der Verminderung oder Erhöhung des reinen Impedanzkoeffizienten des zu prüfenden Elementes entsprechen, unterwerfen; und daß vorgesehen sind: ein Synchronisations-frequenz-Generator; Koinzidenz-Prüfschaltungen (14) zur Feststellung der Koinzidenz zwischen der Synchronisationsfrequenz und einem der von den Verzögerungsschaltungen (13) hervorgerufenen Verzögerungsgrad; Relais (17), die bei festgestellter Koinzidenz von den Koinzidenz-Schaltungen erregt werden; sowie Mittel (18—20), die auf die Normal-Elemente (4,5) selektiv in der erforderlichen Richtung zur Veränderung von deren Kenngrößen und damit Wiederherstellung des Brückengleichgewichts einwirken.

4. Sicherheitssystem nach Anspruch 3, 4 dadurch gekennzeichnet, daß die Synchronisationsfrequenz von der Versorgungsfrequenz der Brücke abgeleitet ist.

5. Sicherheitssystem nach Anspruch 1 oder 2, dadurch gekennzeichnet, daß Mittel zur Zuführung einer von der Versorgungsfrequenz der Brücke abgeleiteten Synchronisationsfrequenz zu Verzögerungsschaltungen (13), die diese Synchronisationsfrequenz jeweils um eine Viertelperiode abgestuft verzögern und deren Ausgänge Koinzidenz-Prüfschaltungen (14) zugeführt sind, vorgesehen sind, und daß die am Ausgang der Brücke (1) zur Feststellung der Verstimmung vorgesehenen Mittel (8/11) mit den Koinzidenz-Prüfschaltungen (14) verbunden sind, derart, daß in einer dieser Schaltungen eine Koinzidenz zwischen dem Verstimmungs-Signal und einem der Signale feststellbar ist, die einer der abgestuft verzögerten Synchronisationsfrequenzen entsprechen, und bei festgestellter Koinzidenz Relais (17) von den Koinzidenzschaltungen (14) erregt und über diese Relais Mittel (18—20) gespeist werden, die selektiv in der zur Änderung der Kenngröße der Normal-Elemente und damit Wiederherstellung des Brückengleichgewichts erforderlichen Richtung auf die Normal-Elemente einwirken.

6. Sicherheitssystem nach einem beliebigen der vorstehenden Ansprüche, gekennzeichnet durch Mittel (8/11) zur Selektion der am Brückenausgang im Verstimmungsfall auftretenden Signale zu deren Trennung von der Versorgungsfrequenz der Brücke.

7. Sicherheitssystem nach einem beliebigen der vorstehenden Ansprüche, gekennzeichnet durch ein in der Schaltung zur Steuerung oder Regelung der Normal-Elemente vorgesehenes Zeitglied (20) zur Verzögerung des Ausgleichs der Verstimmung.

8. Sicherheitssystem nach einem beliebigen der vorstehenden Ansprüche, gekennzeichnet durch eine Brückenschaltung (21), die sich normalerweise im Gleichgewicht befindet, in zwei ihrer Zweige metallische Massen (23, 24) und in den anderen Zweigen Normal-Elemente (25, 26) aufweist; und Mittel (28) zur Feststellung eines Ungleichgewichts der Brücke (1) infolge der Änderung der induktiven Kopplung aufgrund der gegenseitigen Annäherung oder Entfernung dieser metallischen Massen (23, 24).

9. Sicherheitssystem nach einem beliebigen der Ansprüche 1—7, gekennzeichnet durch eine Brückenschaltung, die sich normalerweise im Gleichgewicht befindet, in zwei ihrer Zweige metallische Massen (23, 24) und in den anderen Zweigen Normal-Elemente (25, 26) sowie eine zusätzliche, zu einer der metallischen Massen parallel geschaltete metallische Masse aufweist; und Mittel zur Feststellung eines Ungleichgewichts der Brücke (1) infolge einer Änderung der induktiven Kopplung aufgrund der Annäherung oder Entfernung dieser zusätzlichen metallischen Masse an die bzw. von der ihr zugeordneten metallischen Masse.

10. Sicherheitssystem nach einem beliebigen der Ansprüche 1—7, gekennzeichnet durch eine Brückenschaltung (1), die sich normalerweise im Gleichgewicht befindet, in zwei ihrer Zweige metallische Massen (23, 24) und in den anderen Zweigen Normal-Elemente (25, 26) aufweist; und Mittel (28) zur Feststellung eines Ungleichgewichts der Brücke (1) infolge der Änderung der induktiven Kopplung aufgrund der Nähe eines externen metallischen Gegenstandes zu einer dieser metallischen Massen.

FIG. 1

0 012 092

R1    R2

FIG. 2

Z1    Z2

26    25

22

21

24

27    23

28

FIG. 4

FIG. 3

0 012 092